Europäisches Patentamt

European Patent Office

Office européen des brevets

(11) Numéro de publication: **0 373 069**
**A1**

## (12) DEMANDE DE BREVET EUROPEEN

(21) Numéro de dépôt: 89403373.7

(22) Date de dépôt: 06.12.89

(51) Int. Cl.5: **G01R 31/28**

(30) Priorité: 06.12.88 FR 8815967

(43) Date de publication de la demande:
**13.06.90 Bulletin 90/24**

(84) Etats contractants désignés:
**AT BE CH DE ES FR GB GR IT LI LU NL SE**

(71) Demandeur: **BULL S.A.**
**121, Avenue de Malakoff**
**F-75116 Paris(FR)**

(72) Inventeur: **Quintard, Alain**
**Résidence Bellevue, Bat. C3 Nozay**
**F-91620 La Ville du Bois(FR)**

(74) Mandataire: **Debay, Yves et al**
**BULL S.A. Industrial Property Department**
**P.C.: HQ 8M006 B.P. 193.16 121 avenue de**
**Malakoff**
**F-75764 Paris Cédex 16(FR)**

(54) **Procédé pour le contrôle d'une carte de circuit imprimé équipée, notamment le contrôle des composants de la carte, et appareillage pour la mise en oeuvre de ce procédé.**

(57) L'invention concerne un procédé pour le contrôle d'une carte de circuit imprimé équipée, notamment le contrôle des composants de la carte, et utilisable entre autres pour les cartes équipées de composants à montage en surface (CMS).

Selon l'invention, le procédé de contrôle comporte au moins les phases suivantes :
- activation, notamment mise sous tension, de la carte,
- prise d'une image thermographique de la carte pour une activation donnée, de préférence après établissement d'un équilibre thermique de la carte,
- traitement de l'image par détection d'écart thermique par rapport à un étalon prédéfini pour des composants de la carte à contrôler.

L'invention concerne également un appareillage pour la mise en oeuvre du procédé de contrôle.

FIG. 2

# PROCEDE POUR LE CONTROLE D'UNE CARTE DE CIRCUIT IMPRIME EQUIPEE, NOTAMMENT LE CONTROLE DES COMPOSANTS DE LA CARTE, ET APPAREILLAGE POUR LA MISE EN OEUVRE DE CE PROCEDE

La présente invention concerne un procédé pour le contrôle d'une carte de circuit imprimé équipée, notamment le contrôle des composants de la carte. Par carte de circuit imprimé équipée on entend une carte de circuit imprimé dont l'architecture est bâtie autour d'une couche de matière isolante telle que la résine époxy et comportant un certain nombre de composants électroniques. Parmi ces composants électroniques il faut distinguer deux catégories, les composants passifs tels que les résistances et les condensateurs et les composants actifs tels que les diodes, les transistors et les circuits intégrés. Ces composants sont soudés par utilisation de procédés classiques tel le soudage à la vague ou le soudage par refusion, notamment dans sa variante dite en phase vapeur.

· Au sortir de la fabrication, les cartes sont soumises à une série de tests, d'abord des tests de type passif pour vérifier notamment l'intégrité des circuits électriques, notamment au niveau des soudures, puis des tests de type actif pour vérifier l'aptitude fonctionnelle des cartes. Pour faire ces premiers tests, on utilise généralement un appareil dit "planche à clous" muni d'un grand nombre de pointes qui viennent en contact électrique avec des points du circuit à contrôler. Ces appareils qui donnent de bons résultats, sont cependant relativement délicats à fabriquer et à mettre en oeuvre car ils doivent être adaptés à chaque modèle de carte à contrôler.

Par ailleurs l'introduction de la nouvelle technologie dite des composants à montage en surface (CMS) a permis une miniaturisation des circuits imprimés et de leurs composants, miniaturisation qui pose de réels problèmes pour le contrôle des cartes CMS par ces appareils type "planche à clous". En effet, la dimension minimum des supports de pointe interdit à celles-ci l'accès de zones trop rapprochées. A titre d'exemple, le pas moyen utilisé dans les cartes CMS est de 1,27 mm au lieu de 2,54 mm pour les cartes classiques. Avec l'adoption du nouveau standard de 0,3 mm pour les cartes CMS, les appareils de contrôle type "planche à clous" seront complètement inadaptés voire inutilisables pour certaines opérations.

L'invention propose un procédé destiné à se substituer au contrôle du type "planche à clous" ou tout du moins à limiter très sensiblement son utilisation. Par ailleurs, un procédé de contrôle de cartes de circuit imprimé équipées doit, pour être performant, répondre à un certain nombre de critères, notamment aux suivants:

- Le procédé doit être du type non destructif ; sa mise en oeuvre ne doit pas risquer de détériorer la carte et ses composants.

- Le procédé doit être permettre son automatisation, pour des raisons de cadence, mais aussi pour éliminer toute appréciation humaine variable selon les opérateurs.

- Le procédé doit permettre la localisation immédiate des points défectueux sur la carte (y compris les composants défectueux) afin de pouvoir procéder à des interventions de dépannage ponctuel.

- Enfin, le procédé de contrôle doit être de mise en oeuvre facile, adaptable aux divers modèles de carte, rapide et relativement peu onéreux.

A ces fins, l'invention propose un procédé pour le contrôle d'une carte de circuit imprimé équipée, notamment le contrôle des composants de la carte, caractérisé en ce qu'il comporte au moins les phases suivantes :

- activation, notamment mise sous tension, de la carte,

- prise d'une image thermographique de la carte pour une activation donnée, de préférence après établissement d'un équilibre thermique de la carte,

- traitement de l'image par détection d'écart thermique par rapport à un étalon prédéfini pour des régions à contrôler de la carte, par exemple les régions occupées par les composants de la carte.

Selon une variante de l'invention, le seuil prédéterminé de l'écart thermique considéré comme admissible pour le contrôle des composants est choisi en fonction du composant et des conditions d'environnement et d'activation de la carte.

Selon une autre variante de l'invention, la prise d'image est effectuée par une caméra infra-rouge, par exemple du type à détecteur quantique (photo-excité) travaillant dans un domaine spectral compris entre 8 et 12 microns.

Selon une autre variante du procédé de l'invention, une image étalon est définie pour chaque modèle de carte avec repérage géographique à deux dimensions de la localisation de points sélectionnés du circuit imprimé et de ses composants équipant la carte. Pour finir, il est prévu l'affichage de la localisation vraie de la région reconnue défectueuse, par exemple du composant reconnu défectueux.

Selon encore une autre variante du procédé de l'invention, l'étalon est créé par mixage d'une pluralité d'images obtenues à partir de cartes de référence de même modèle réputées admissibles, dans des conditions d'activation et d'environnement comparables. De plus cet étalon est paramétrable.

L'invention concerne également un appareillage pour la mise en oeuvre du procédé défini ci-dessus, l'appareillage étant caractérisé en ce qu'il comporte :

- un support de carte muni d'un agencement permettant le repérage géographique à deux dimensions d'un point quelconque de la carte, ci-après appelé localisation vraie,
- une chaîne de commande d'activation,

- une chaîne de prise d'image, comportant une caméra infra-rouge et un convertisseur générant par relevé d'image unitaire un bloc d'informations comportant pour chaque point image du champ image de la caméra la localisation image correspondante et un signal de mesure représentatif de la température au point objet associé de la carte couvert par le champ élémentaire objet de la caméra,
- un dispositif de pointage du champ de la caméra associé audit support de carte, ledit agencement de repérage géographique étant adapté pour effectuer le repérage du positionnement du champ de la caméra par rapport à la carte,
- une chaîne de traitement d'image comportant :
  . des moyens de stockage d'un bloc d'informations correspondant à un relevé d'image unitaire,
  . des moyens associés audit agencement de repérage géographique, pour déterminer la localisation vraie du point objet associé à une localisation image donnée d'un bloc d'information correspondant à un relevé d'image unitaire donné et apparier chaque signal de mesure à une localisation vraie,
  . des moyens de stockage d'une image étalon constituée d'un ensemble de signaux étalons, chaque signal étalon étant apparié avec la localisation vraie d'un point objet de la carte,
  . des moyens de comparaison, pour une même localisation vraie, du signal de mesure avec le signal étalon et,
  . des moyens d'affichage de la localisation vraie concernée et du résultat de l'opération de comparaison.

Selon un mode de réalisation de l'appareillage utilisé, la chaîne de commande d'activation de la carte est susceptible de commander l'activation de sous-circuits particuliers, par exemple des opérations lecture/écriture dans des mémoires dynamiques RAM.

Selon un mode de réalisation particulier de l'appareillage selon l'invention, le support de carte comporte, outre ledit agencement de repérage géographique, un bâti fixe portant le dispositif de pointage du champ de la caméra et muni de moyens de guidage de la carte. Avantageusement l'agencement de repérage géographique comporte une station pilote pour effectuer le repérage du positionnement du champ de la caméra. De plus, la station pilote commande les chaînes de prise et de traitement d'image et gère un processus de relevé et de traitement d'images. Enfin, la station pilote transmet aux moyens pour apparier chaque signal de mesure à une localisation vraie et présents dans ladite chaîne de traitement d'image des informations concernant le positionnement instantané du champ de la caméra par rapport à la carte utilisée lors de chaque relevé d'image. Selon encore un autre mode de réalisation particulier de l'appareillage selon l'invention, la station pilote, la chaîne de commande et la chaîne de traitement de l'image sont du type à calculateur digital chargé de logiciels et de fichiers d'exploitation adaptés au modèle de carte à explorer. Avantageusement, la station pilote et la chaîne de commande d'activation sont coordonnées par l'unité centrale d'un calculateur digital commun.

L'invention est maintenant décrite en référence aux figures ci-annexées dans lesquelles :

- La figure 1 est une représentation schématique d'une carte de circuit imprimée équipée illustrant le repérage géographique de points donnés de la carte.

- La figure 2 est une représentation schématique d'un appareillage de mise en oeuvre du procédé selon l'invention.

Le procédé selon l'invention est basé sur la prise d'images thermographiques par un détecteur infra-rouge soumis au rayonnement thermique du circuit activé et plus particulièrement des composants eux-mêmes. Plus précisément le procédé de contrôle selon l'invention comporte au moins les trois étapes suivantes :

- activation, notamment mise sous tension, de la carte,
- prise d'une image thermographique de la carte pour une activation donnée, de préférence après établissement d'un équilibre thermique de la carte,
- traitement de l'image par détection d'écart thermique par rapport à un étalon prédéfini pour des composants de la carte à contrôler .

Dans le mode de mise en oeuvre du procédé selon l'invention ici décrit à titre d'exemple non limitatif, la prise d'image est effectuée , de préférence en temps réel, par une caméra infra-rouge du type à détecteur quantique (photo-excité) travaillant dans un domaine spectral compris entre 8 et 12 microns. Cette caméra mesure dans le spectre infra-rouge l'énergie calorifique rayonnée aux divers points de la carte en particulier par les composants (par exemple à la surface même de ceux-ci) et fournit un signal de mesure correspondant à la température de la surface explorée. Il est intéressant de remarquer que ce type de caméra utilisé permet d'une part de faire des mesures dans des domaines de températures peu élevées, de l'ordre par exemple de 50°C, sans risquer de détériorer la carte ou ses composants, d'autre part en travaillant en temps réel de procéder très rapidement à des prises d'images répétées. Cette dernière caractéristique est particulièrement intéressante dans certains cas d'activation dynamique de la carte où l'équilibre thermique, si toutefois il est atteint, reste fugace.

Le contrôle selon l'invention est de type relatif par référence à un étalon prédéfini. Il importe donc de s'assurer de la répétibilité des mesures, tout particulièrement dans le cas où, selon une variante de l'invention, l'étalon est obtenu à partir d'images thermographiques. Pour ce faire, outre le respect d'un mode opératoire préétabli, l'environnement et l'activation de la carte doivent être rigoureusement contrôlés dans l'espace et dans le temps pour travailler sur des bases identiques ou tout du moins comparables.

En ce qui concerne l'activation de la carte, on distingue le régime statique (simple mise sous tension des circuits de la carte) du régime dynamique dans lequel certains sous-circuits sont activés d'une façon donnée pendant un temps donné (par exemple envoi d'une série d'ordres de lecture/écriture dans des mémoires dynamiques RAM). En régime statique la température de surface des composants se stabilise en général au bout d'une dizaine de secondes entre 40 et 50° C. En régime dynamique, la mesure est plus délicate et nécessite un étalonnage précis. A défaut il est possible, en utilisant une caméra infra-rouge à prise d'images en temps réel, de surveiller la courbe de montée en température en un point cible situé dans le champ de la caméra pour ne réaliser la mesure proprement dite qu'après stabilisation de la température de surface de la cible. D'une façon générale, il est préférable de procéder à des relevés d'images thermiques qu'après établissement d'un équilibre thermique de la carte (ou de la région à explorer). Toutefois il est possible de travailler en mode transitoire pour autant que les chaînes de commande d'activation et de prise d'image soient bien coordonnées dans le temps.

En ce qui concerne l'environnement de la carte , il importe de travailler dans un espace à température ambiante stabilisée et constante, à l'abri des turbulences thermiques et des rayonnements thermiques parasites. Ainsi après pré-étude de la manifestation thermique des défauts chez les divers composants, l'écart thermique admissible pour chaque composant est préselectionné en tenant compte des conditions d'environnement et d'activation de la carte puis incorporé dans l'étalon. Cet écart peut être positif ou négatif (en particulier pour un circuit intégré hors service). A titre d'exemple de manifestation thermique, il est possible de déceler une inversion du montage de condensateurs orientés du fait de leur échauffement anormal.Parmi les autres défauts décelables, on peut noter l'absence du composant et une erreur sur le type du composant (en effet la puissance dissipée par certains composants dépend de leur type Rapide ou Lent).

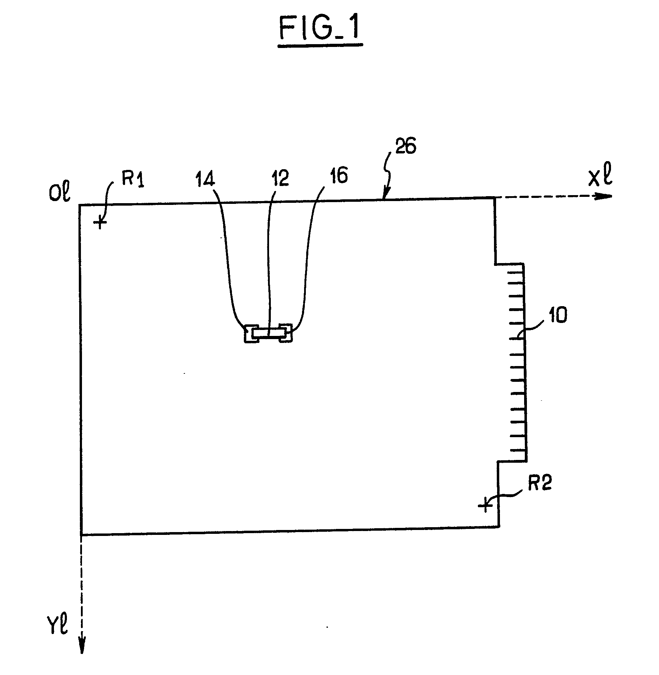

D'une façon générale, la disposition de la caméra par rapport à la carte est telle que le champ spatial de la caméra, couvre la carte dans son entier. Dans le cas de carte de dimensions supérieures à 200 x 160 mm, il est possible de réaliser le contrôle par relevés successifs d'images des portions (ou zones à contrôler) de la carte. La figure 1 illustre schématiquement une carte avec ses axes oIXI,oIYI de coordonnées vraies locales d'origine oI et les points d'indexation et de repérage R1 et R2 de la carte par rapport à un support quelconque (par exemple le bâti du poste de montage des composants sur la carte). Sur la figure 1 est également montré schématiquement un composant 12 (par exemple une résistance montée en surface) avec ses deux points de soudure 14 et 16. Par définition on considère que l'aire d'exploration du composant 12 est constituée par la région de la carte recouverte par le composant 12. De plus un repérage géographique permet de localiser sur la carte les diverses régions et/ou composants à contrôler. Plus précisément on réalise pour chaque modèle de carte une grille géographique qui servira de base à une image étalon avec laquelle sera comparée l'image de la carte à contrôler. D'une façon pratique, la grille de base est réalisée à partir de données qui ont été élaborées lors du dessin du circuit imprimé et de la carte complète avec l'aide d'un programme de Conception Assistée par Ordinateur, C.A.o. L'image étalon est créée par mixage (par exemple par moyennage) d'une pluralité d'images obtenues à partir de cartes de référence de même modèle. Optionnellement cette image étalon est paramétrée, notamment pour tenir compte, si nécessaire, du composant, des conditions d'environnement et d'activation de la carte et du mode opératoire.

On procède, de préférence après établissement d'un équilibre thermique de la carte ou tout du moins de la région à contrôler, au relevé d'une image thermique étant entendu que la position relative du champ de la caméra par rapport à la carte est transmise à la chaîne de traitement d'image pour permettre à celle-ci d'associer un point d'image à une localisation vraie sur la carte. Ainsi donc l'aire d'exploration correspondant à un composant défectueux est identifiée (par le code du composant), localisée et affichée. Pour les cartes de grandes dimensions, au terme de chaque traitement d'image, la carte est déplacée latéralement par rapport au champ de la caméra pour permettre la prise d'image d'une nouvelle portion de la carte jusqu'à exploration complète de la carte.

Il est entendu que le procédé selon l'invention peut donner lieu à un grand nombre de variantes, selon les désirs de l'expérimentateur et en tenant compte de chaque situation pratique. Néanmoins ces variantes devront respecter les trois phases opératoires caractéristiques de l'invention.

L'exposé qui précède a permis de mettre en évidence quelques avantages très intéressants du procédé selon l'invention. Parmi ceux-ci, il faut noter la facilité offerte par le procédé selon l'invention à une automatisation très poussée du contrôle de la carte activée et tout particulièrement des composants, automatisation qui permet d'éliminer l'intervention humaine dans l'appréciation des défauts . Par ailleurs le principe même d'un contrôle optique permet, si nécessaire, une résolution spatiale très fine entre deux points à contrôler, pour atteindre des valeurs inférieures au millimètre interdites au contrôle par "planche à clous". Enfin, en faisant appel aux programmes informatiques et aux fichiers utilisés en C.A.o. pour le dessin de la carte à contrôler, il est possible de modifier la grille des régions (et des composants) à contrôler d'un modèle de carte et par là même les images étalons sans difficulté majeure ni délai important. Il est à noter également que l'invention est utilisable pour des contrôles en fin de fabrication mais aussi pour des réparations après mise en service de la carte. D'autres avantages de l'invention apparaîtront à la lecture de la suite de la description qui concerne plus particulièrement un mode de réalisation d'un appareillage pour mettre en oeuvre le procédé selon l'invention.

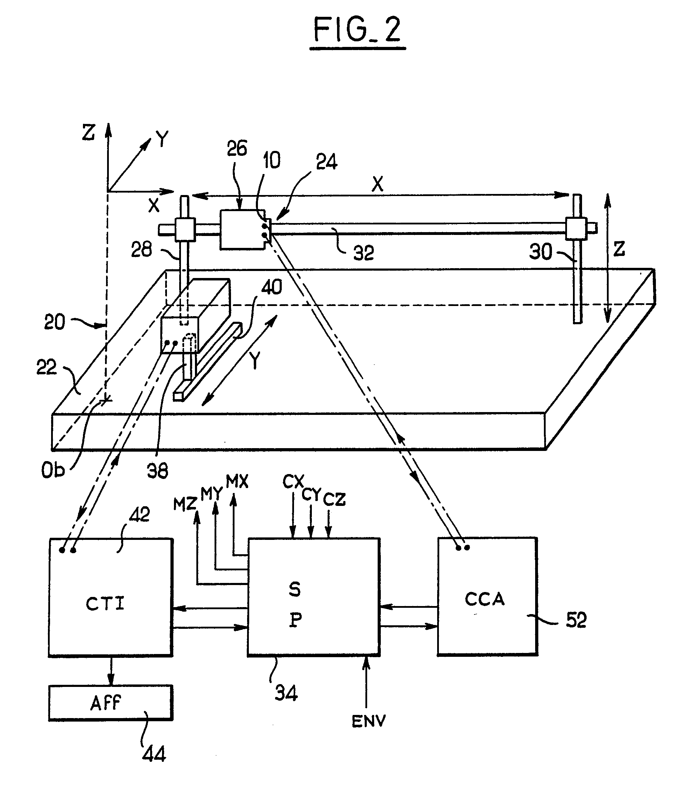

L'appareillage selon l'invention, illustré schématiquement à la figure 2, est structuré physiquement autour d'un support de carte 20 constitué d'un bâti 22, telle qu'une table optique anti-vibratoire en granit. La surface de la table comporte un réseau d'inserts taraudés permettant la fixation et le repérage spatial de divers éléments du banc de contrôle. Sur le bâti 22 sont solidarisés des moyens de guidage 24 pour la carte 26. Ces moyens de guidage se composent de rails en X plus précisément de deux rails verticaux 28 et 30 porteurs d'un rail horizontal 32 sur lequel peut également se déplacer un chariot mobile du type à déplacements bidirectionnels perpendiculaires (non représenté sur la figure 2), porteur de la carte 26. Le chariot présente des pions qui, en coopération avec les repères R1-R2 de la carte, permettent le maintien mais aussi la localisation très précise de la carte 26 par rapport au bâti 22.

L'agencement ainsi décrit permet de définir un repère tridimensionnel en X, Y, Z, d'origine Ob, l'axe des X s'étendant parallèlement au rail horizontal 32, l'axe des Z (ou axe vertical) s'étendant parallèlement aux rails 28 et 30. Sur le chariot porteur de carte sont prévus deux moteurs pas à pas couplés avec des capteurs de position (MX et CX pour le déplacement du chariot mobile sur le rail 32, et MZ et CZ pour le positionnement vertical de la carte sur le chariot). Ces moteurs et capteurs (non représentés sur la figure 2 mais seulement identifiés) sont reliés à une station pilote SP 34 du type à calculateur digital. Ainsi donc la station pilote 34 est capable de repérer la localisation vraie du point Ob par rapport au point origine o1 de la carte et ainsi la localisation de chaque point des composants de la carte. De plus la station pilote commande les moteurs pas à pas MX et MZ de façon à permettre des déplacements par translation de la carte dans un plan parallèle au plan ObX,obZ.

Le bâti 22 supporte également une caméra infra-rouge 36 montée sur un dispositif de pointage du champ de la caméra 38 lui-même monté coulissant sur une glissière 40 solidaire du bâti 22 et s'étendant parallèlement à l'axe des Y. Ici encore le mouvement du dispositif de pointage 38 du champ de la caméra (dans le mode de réalisation ici décrit, de la caméra elle-même) est commandé par un moteur pas à pas MY (non représenté) contrôlé par la station pilote 34 en fonction des informations données par le capteur associé CY. Ainsi la station pilote 34 est en mesure de faire un repérage instantané du positionnement relatif du champ de la caméra par rapport à la carte. Cette particularité importante pour la mise en oeuvre de l'invention peut toutefois, sans sortir du cadre de l'invention, être obtenue d'une autre façon que celle ici décrite (déplacements relatifs latéraux entre la carte et la caméra) notamment par l'intermédiaire d'un dispositif optique à balayage convenablement disposé dans le chemin optique objectif-caméra/carte. La caméra qui sera décrite plus en détail par la suite est reliée à une chaîne de traitement d'image CTI 42 du type à calculateur digital munie de son dispositif d'affichage 44 tel que écran-vidéo et/ou imprimante et/ou table traçante.

L'appareillage selon l'invention comporte de plus une chaîne de commande d'activation CCA 52 convenablement connectée à la carte 26 par l'intermédiaire de la barrette de contacts 10 disposée sur le côté droit de celle-ci par rapport aux figures. La chaîne CCA 52 commande, outre l'alimentation de la carte, l'activation de certains sous-circuits de façon selective et préprogrammée. Toutefois la chaîne CCA 52 travaille sous le contrôle global de la station pilote 34.

La station pilote 34 est structurée autour d'un micro-ordinateur BULL MICRAL modèle 40 (BM 40) convenablement chargé de son logiciel d'exploitation. Malgré des courses utiles assez importantes des moyens de guidage 24 et de la glissière 40, X = 1250 mm, Y = 630 mm, Z = 400 mm, la précision géographique obtenue est de l'ordre de 0,01 mm en utilisant des moteurs dont le pas unitaire de déplacement est de 0,127 mm.

La caméra infra-rouge 36 utilisée est commercialisée par la société INFRAMETRICS de Bedford (E.U.A.) sous l'appellation "Modèle 600". Plus précisément cette caméra du type à balayage avec un entrelacement d'ordre 2, est équipée d'un détecteur quantique Hg-Cd-Te refroidi à l'azote liquide opérant dans une bande spectrale de 8 à 12 microns. Le champ de la caméra est défini par l'angle de balayage du détecteur soit 20° H(horizontal) et 15° V(vertical). Ceci permet une résolution de 256 points images sur 240 lignes. En choisissant un réglage de la caméra correspondant à un recouvrement par la caméra d'une zone unitaire d'exploration de 210 x 156 mm, on obtient une résolution vraie sur la carte de 0,78 mm/H et de 0,66 mm/V. Le signal de mesure fourni par chaque point image est numérisé sous 7 bits, ce qui correspond à 128 niveaux de luminance thermique mesurables. La précision obtenue est de l'ordre de 0,1°C. La vitesse de prise d'image thermique est assez élevée de l'ordre de 20 millisecondes pour la trame et de 55 microsecondes par ligne.

A la réception d'un ordre de relevé d'image unitaire, la caméra transmet à la chaîne CTI 42, par l'intermédiaire d'un convertisseur digital, un bloc d'informations comportant le signal "video" représentatif de la mesure de la température en un point de la carte accompagné de signaux de synchronisation permettant de positionner les débuts des balayages lignes et trames (et par voie de conséquence d'effectuer le repérage des points images). La chaîne de traitement d'image CTI 42 est structurée autour d'un micro-ordinateur BULL MICRAL Modèle 60 (BM 60), asservi comme expliqué par la suite à la station pilote 34 c'est à dire au micro BM 40. Le sous-système informatique constituant la chaîne CTI 42 présente la capacité de mémoire centrale et périphérique suffisante pour traiter et conserver des "images" de cartes dont chaque unité demande une capacité disponible de 128 Koctets. Ce sous-système informatique comporte outre des moyens de stockage d'un bloc d'informations provenant du convertisseur de la caméra, les moyens matériels et logiciels pour déterminer, à partir d'un signal de positionnement et transmis par la station pilote 34, la localisation vraie des points objets associés à chaque point image et ainsi d'apparier une localisation vraie sur la carte à chaque signal de mesure. La première phase du traitement de l'image se termine par la mise en mémoire de l'image ainsi retraitée ou de parties prédéfinies de celle-ci selon une grille géographique préétablie et existante dans un fichier de la chaine CTI 42.

La chaîne CTI 42 comporte également en mémoire une image étalon formée selon la même grille correspondante à un modèle de carte prédéterminé. L'image étalon peut être créée de toute pièce par programmation, cependant il s'est avéré intéressant et plus rapide de créer cette image par mixage (par exemple moyennage des valeurs mesurées) d'une pluralité d'images thermographiques obtenues dans les mêmes conditions opératoires, notamment d'environnement et d'activation de la carte, à partir de l'exploration d'au moins dix cartes réputées admissibles. Bien évidemment, comme mentionné précédemment, cette image étalon peut être retravaillée si nécessaire à l'aide de logiciels mettant en jeu divers paramétrages.

La chaîne CTI 42 est ainsi en mesure de faire une comparaison point par point (limités à ceux présélectionnés de la grille) des signaux de mesure avec les valeurs étalons et afficher au travers des moyens d'affichage 44, l'identification et la localisation de la région défectueuse, (par exemple le code et la localisation d'un composant) dans laquelle la température de surface d'au moins un point élémentaire exploré de la carte (0,78x0,66 mm) s'écarte de la température étalon au même point de plus du seuil d'écart autorisé. Bien entendu, la valeur absolue du seuil d'écart autorisé peut être différente selon le sens (négatif ou positif) de l'écart de température par rapport à la température étalon.

De plus l'appareillage selon l'invention permet d'effectuer aisément toutes les opérations de comptage et statistiques souhaitées pour assiter la mise au point et le contrôle d'un processus de fabrication automatique. Pour chaque nouveau modèle de carte, l'opérateur procédera aux opérations préalables suivantes :

- Détermination, à partir des fichiers et programmes C.A.O. correspondants aux dessins de la carte, de la grille géographique des régions, en particulier des composants, à contrôler et chargement d'un fichier "grille" particulier en mémoire dans le sous-système informatique BM 60 de la chaîne 42.

- Découpage virtuel de la carte à partir du fichier "grille" en zones d'exploration unitaires et mise en mémoire dans les sous-systèmes BM 40 et BM 60 de la séquence des positionnements relatifs caméra/carte de chaque zone d'exploration unitaire.

- Sélection pour la chaîne CCA 52 d'un programme d'activation.

- Sélection d'une dizaine de cartes réputées admissibles et réalisation des relevés des images thermographiques de référence correspondantes.

- Elaboration de l'image étalon par mixage et paramétrage éventuel des images de référence. (A noter qu'il est possible de tester les images de référence par rapport à l'image étalon et de faire des études de dispersion selon les régions et en particulier les aires d'accueil à contrôler).

- Mise en mémoire de l'image étalon.

Ainsi donc les sous-systèmes informatiques BM 40 et BM 60 sont chargés de leurs logiciels d'exploitation et des fichiers adaptés aux divers modèles de cartes à contrôler. Il est alors possible de procéder au contrôle d'une carte de série selon un modèle prérépertorié au sortir de la fabrication ou dans le cadre d'opérations de maintenance. Ce contrôle se déroule de la façon suivante:

. Après la mise en place de la carte sur son chariot, l'opérateur donne un top manuel (ENV) à la station pilote SP 34. La station pilote 34 positionne carte et caméra de façon à faire couvrir par cette dernière la carte ou la portion à explorer. Un signal de fin de positionnement, obligatoire pour déverrouiller l'opération de relevé d'image pour la zone considérée, sera alors généré dans la station pilote 34. De façon simultanée, la station pilote 34 fait exécuter à la chaîne CCA 52 son programme préétabli d'activation (adapté à la carte ou à la portion de carte à explorer). Le relevé de l'image thermique ne sera commandé par la station pilote 34 qu'après un délai de temporisation par rapport à l'instant origine de la phase d'activation (temporisation qui est fonction de l'activation en cours) ou après l'apparition d'un signal confirmant l'équilibre thermique de la carte. La station pilote transmettra alors à la chaîne CTI 42 un top de prise d'image par la caméra. L'image de la caméra est ainsi relevée en temps réel et transmise vers la chaîne de traitement d'image CTI 42 qui reçoit de plus de la station pilote, avec le top de prise d'image, un signal de situation du positionnement du champ de la caméra par rapport à la carte. Grâce à ce signal de situation, la chaîne CTI 42 est en mesure de restituer la localisation vraie de chaque point objet exploré pour lequel un signal de mesure est généré par le convertisseur digital de la caméra 36. Un signal de fin de relevé d'image est alors transmis par la chaîne CTI 42 à la station pilote 34 qui peut, si nécessaire, positionner la caméra par rapport à une nouvelle position à explorer de la carte, en fait par translation de la carte. Entre-temps la chaîne CTI 42 procède à la reconstrution de l'image en localisation vraie et au test de comparaison. Les résultats de ce test de comparaison sont mis sur une mémoire tampon pour être affichés en temps différé. Par contre dès la fin du traitement de l'image proprement dite, un top de fin de traitement est adressé à la station pilote 34 par la chaîne CTI 42.

Dans le cas de contrôle de la carte par portion, dès la perception par la station pilote 34 des deux signaux de fin de traitement d'image (T.I. = 0) et de fin de positionnement, la station pilote 34 émet un nouveau signal de top de prise d'image (P.I. = 1) avec génération d'un nouveau signal de situation. Ceci se répétera jusqu'à l'exploration complète de la carte.

Bien entendu l'appareillage selon l'invention n'et pas limité aux matériels ici décrits que ce soit, en particulier, au niveau de l'activation de la carte ou au niveau de la caméra infra-rouge. Sans sortir du cadre de l'invention d'autres variantes utilisent soit une caméra à transfert de charge (type CCD) soit une caméra à balayage linéaire. Dans ce dernier cas, la carte défile devant la caméra en synchronisme avec le balayage de la caméra. Il est toutefois nécessaire que la caméra présente un champ d'envergure suffisante pour couvrir complètement soit la hauteur soit la longueur de la carte.

**Revendications**

1. Procédé pour le contrôle d'une carte de circuit imprimé équipée, notamment le contrôle des composants de la carte, caractérisé en ce qu'il comporte au moins les phases suivantes :
- activation, notamment mise sous tension, de la carte (26),
- prise d'une image thermographique de la carte pour une activation donnée, de préférence après établissement d'un équilibre thermique de la carte,
- traitement de l'image par détection d'écart thermique par rapport à un étalon prédéfini pour des composants (12) de la carte à contrôler.

2. Procédé selon la revendication 1, caractérisé en ce que le seuil prédéterminé de l'écart thermique considéré comme admissible pour le contrôle des composants est choisi en fonction du composant et des conditions d'environnement et d'activation de la carte.

3. Procédé selon l'une des revendications précédentes, caractérisé en ce que la prise d'image est effectuée, de préférence en temps réel, par une caméra infra-rouge (36), notamment par une caméra infra-rouge (36) du type à détecteur quantique (photo-excité) travaillant dans un domaine spectral compris entre 8 et 12 microns.

4. Procédé selon l'une des revendications précédentes, caractérisé en ce qu'une image étalon est définie pour chaque modèle de carte avec un repérage géographique à deux dimensions de la localisation de points sélectionnés du circuit imprimé et de ses composants équipant la carte.

5. Procédé selon la revendication 4, caractérisé en ce que le repérage géographique réalise la localisation vraie des divers composants à contrôler de la carte.

6. Procédé selon la revendication 5, caractérisé en ce qu'il est prévu l'affichage de la localisation vraie du composant reconnu défectueux.

7. Procédé selon l'une des revendications 5 et 6, caractérisé en ce que l'opération de détection d'écart thermique n'est effectuée que sur les portions d'images correspondantes à une grille géographique prédéfinie des composants à contrôler de la carte.

8. Procédé selon l'une des revendications précédentes, caractérisé en ce que l'étalon est créé par mixage d'une pluralité d'images obtenues à partir de cartes de référence de même modèle réputées admissibles, selon le même mode opératoire et dans des conditions d'activation et d'environnement comparables.

9. Procédé selon l'une des revendications précédentes, caractérisé en ce que l'étalon est paramétrable.

10. Appareillage pour la mise en oeuvre du procédé selon l'une des revendications précédentes caractérisé en ce qu'il comporte :
- un support de carte (20) muni d'un agencement permettant (CX,CY,CZ,34) le repérage géographique à deux dimensions d'un point quelconque de la carte, ci-après appelé localisation vraie,
- une chaîne de commande d'activation CCA (52),
- une chaîne de prise d'image, comportant une caméra infra-rouge (36) et un convertisseur générant par relevé d'image unitaire un bloc d'informations comportant pour chaque point image du champ image de la caméra la localisation image correspondante et un signal de mesure représentatif de la température au point objet associé de la carte couvert par le champ élémentaire objet de la caméra,
- un dispositif de pointage du champ de la caméra (38) associé audit support de carte (20), ledit agencement de repérage géographique (CX, CY, CZ, 34) étant adapté pour effectuer le repérage du positionnement du champ de la caméra par rapport à la carte,
- une chaîne de traitement d'image CTI (42) comportant:
. des moyens de stockage d'un bloc d'informations correspondant à un relevé d'image unitaire,
. des moyens associés audit agencement de repérage géographique (CX, CY, CZ, 34), pour déterminer la localisation vraie du point objet associé à une localisation image donnée d'un bloc d'information correspondant à un relevé d'image unitaire donné et apparier chaque signal de mesure à une localisation vraie,
. des moyens de stockage d'une image étalon constituée d'un ensemble de signaux étalons, chaque signal étalon étant apparié avec la localisation vraie d'un point objet de la carte,
. des moyens de comparaison, pour une même localisation vraie, du signal de mesure avec le signal étalon et,
. des moyens d'affichage (44) de la localisation vraie concernée et du résultat de l'opération de comparaison.

11. Appareillage selon la revendication 10, caractérisé en ce qu'il comporte des moyens de présélection des localisations vraies de la carte pour lesquels l'opération de comparaison doit être effectuée.

12. Appareillage selon l'une des revendications 10 et 11, caractérisé en ce que le signal étalon, pour une même localisation vraie, est élaboré par la chaîne de traitement d'image (42) à partir d'une pluralité de signaux de mesure relevés selon le même mode opératoire pour la même localisation vraie sur plusieurs cartes de même modèle réputées admissibles, dans des conditions d'activation et d'environnement de la carte comparables, le signal étalon étant, de façon optionnelle, paramétrable.

13. Appareillage selon la revendication 10, caractérisé en ce que la chaîne de commande d'activation de la carte (52) est susceptible de commander l'activation de sous-circuits particuliers, par exemple des opérations lecture/écriture dans des mémoires dynamiques RAM.

14. Appareillage selon l'une des revendications 10 à 13, caractérisé en ce que ledit support de carte (20) comporte, outre ledit agencement de repérage géographique, un bâti fixe (22) portant ledit dispositif de pointage du champ de la caméra et muni de moyens de guidage (24) de la carte.

15. Appareillage selon la revendication 14, caractérisé en ce qu'une station pilote (34) commande la chaine de commande d'activation (52) et les chaînes de prise et de traitement d'image (36,42) et gère un processus de relevé et de traitement d'images.

16. Appareillage selon la revendication 15, caractérisé en ce que ladite station pilote (34) effectue le repérage du champ de la caméra par rapport à la carte, transmet auxdits moyen pour apparier chaque signal de mesure à une localisation vraie, présents dans ladite chaîne de traitement d'image, des informations concernant le positionnement instantané du champ de la caméra par rapport à la carte utilisé lors de chaque relevé d'image.

17. Appareillage selon l'une des revendications 15 et 16, caractérisé en ce que la station pilote (34) comporte au moins un calculateur digital chargé de logiciels et de fichiers d'exploitation adaptés au modèle de carte à contrôler.

18. Appareillage selon l'une des revendications 10 et 16, caractérisé en ce que la chaîne de commande d'activation (52) comporte au moins un calculateur digital chargé de logiciels et de fichiers d'exploitation adaptés au modèle de carte à contrôler.

19. Appareillage selon les revendications 17 et 18 prises en combinaison, caractérisé en ce que la station pilote (34) et la chaîne de commande d'activation (52) sont coordonnées par l'unité centrale d'un calculateur digital commun.

20. Appareillage selon l'une des revendications 10 à 19, caractérisé en ce que ladite chaîne de traitement d'image (42) est du type à calculateur digital chargé de logiciels et de fichiers d'exploitation adaptés au modèle de carte à contrôler.

# FIG_1

# FIG_2

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| X | US-A-3 868 508 (WESTINGHOUSE) <br> * Résumé; colonnes 7,8, revendication 1; colonne 10, revendication 9 * | 1-12 | G 01 R 31/28 |
| Y | | 13-20 | |
| Y | EP-A-0 247 308 (IBM) <br> * Colonne 20, lignes 21-35 * | 13 | |
| Y | EP-A-0 277 502 (OMRON) <br> * Résumé * | 14-20 | |
| A | MESURES, REGULATION AUTOMATISME, vol. 50, no. 8, 28 mai 1985, pages 41,43,45, Paris, FR; "Réparation de cartes: il ne manque plus que le robot" <br> * Page 43, colonne de droite, en haut * | | |
| A | ELECTRONICS TEST, vol. 11, no. 6, juin 1988, pages 89-90,92, San Francisco, CA, US; K. POMEROY: "Pinpointing shorts with color thermography" | | |

**DOMAINES TECHNIQUES RECHERCHES (Int. Cl.5)**

G 01 R 31/00

Le présent rapport a été établi pour toutes les revendications

| Lieu de la recherche | Date d'achèvement de la recherche | Examinateur |
|---|---|---|
| LA HAYE | 14-03-1990 | TRELEVEN C. |

EPO FORM 1503 03.82 (P0402)